# EUROPÄISCHE PATENTSCHRIFT

(11) **EP 1 082 567 B1**
(45) Veröffentlichungstag und Bekanntmachung des Hinweises auf die Patenterteilung: **09.06.2004**
(21) Anmeldenummer: 00918677.6
(22) Anmeldetag: 25.02.2000
(51) Int. Cl.: F16K 31/00, F02M 51/06, F02M 59/46

(54) **PIEZOELEKTRISCHER AKTOR**
PIEZOELECTRIC ACTUATOR
ACTIONNEUR PIEZOELECTRIQUE

(30) Priorität: 30.03.1999 DE 19914411
(43) Veröffentlichungstag der Anmeldung: 14.03.2001
(73) Patentinhaber: ROBERT BOSCH GMBH, 70442 Stuttgart (DE)
(72) Erfinder: HEINZ, Rudolf, D-71272 Renningen (DE)
(86) Internationale Anmeldenummer: PCT/DE2000/000533
(87) Internationale Veröffentlichungsnummer: WO 2000/060259

(56) Entgegenhaltungen:
- DE-A- 3 039 972
- US-A- 4 051 396
- US-A- 4 284 263
- US-A- 5 295 288

## Beschreibung

### Stand der Technik

Die Erfindung betrifft einen piezoelektrischen Aktor, insbesondere zur Betätigung von Steuerventilen oder Einspritzventilen in Kraftfahrzeugen, mit einem in Form eines vielschichtigen Laminats aus aufeinandergeschichteten Lagen piezoelektrischen Materials und dazwischenliegenden metallischen bzw. elektrisch leitenden, als Elektroden dienenden Schichten gebildeten Aktorkörper, an dessen Endflächen je eine ventilseitige Kopfplatte mit einem axial ragenden Ventilstößel und eine gegenüberliegende Fußplatte angebracht sind, wobei der Aktor in einer Axialbohrung eines Ventilgehäuses sitzt und stirnseitig zwischen der Kopfplatte und der Fußplatte durch ein Federelement in axialer Richtung vorgespannt ist.

Ein solcher piezoelektrischer Aktor ist z. B. aus der DE 196 50 900 A1 der Robert Bosch GmbH bekannt.

Derartige piezoelektrische Mehrlagenaktoren führen, wenn sie mit einer pulsierenden elektrischen Spannung an ihren Elektrodenschichten beaufschlagt werden, analog pulsierende Hübe unter Änderung des Abstandes zwischen ihren beiden Stirnseiten aus. Der Mehrlagen-Piezoaktor wird mit Spannungen betrieben, die zu hohen Feldstärken führen. Üblich sind Feldstärken von 2 kV/mm bis 3 kV/mm. Die Betriebsspannung liegt bei 100 V bis 250 V. Der piezoelektrische Mehrlagenaktor muß im Stahlgehäuse des Einspritzventils so gelagert werden, daß keine Kurzschlüsse entstehen. Gefordert wird somit ein zentrierter Einbau mit definiertem Abstand zur Außenwand, so daß keine Gefahr von Kurzschlüssen zwischen dem Aktorkörper und der Außenwand besteht.

Im Betrieb solcher piezoelektrischer Mehrlagenaktoren entsteht im Aktorkörper Wärme, die, um Zerstörungen und Beeinträchtigungen der Funktionsweise des piezoelektrischen Aktors zu vermeiden, nach außen, d. h. z. B. zum Ventilgehäuse des Einspritz- oder Steuerventils abgeführt werden muß.

Bei der oben genannten DE 196 50 900 A1 ist der Aktor, um ihn innerhalb des Ventilgehäuses zu zentrieren, zwischen seiner Kopfplatte und seiner Fußplatte mittels einer unter einer größeren Zugspannung stehenden Federhülse derart eingespannt, daß die Kopfplatte und die Fußplatte den Aktorkörper einer entsprechenden Druckvorspannung aussetzen. In diesem Fall nimmt die Federhülse die vom Aktorkörper erzeugte Wärme auf, führt sie nach außen ab und sorgt gleichzeitig für die zur Isolation notwendige Zentrierung des Aktorkörpers im Ventilgehäuse.

Gemäß dem Patent DE 197 15 488 C1 der Siemens AG ist ein Aktorkörper mit einer Polymerumhüllung umgeben, die zwischen sich und der Innenwand des Ventilgehäuses einen Luftspalt offen läßt. Dadurch entsteht der Nachteil, daß die Wärmeabfuhr zum Ventilgehäuse durch den Luftspalt erschwert ist.

### Aufgabe und Vorteile der Erfindung

Angesichts des oben gesagten ist es Aufgabe der Erfindung, einen gattungsgemäßen piezoelektrischen Aktor zu ermöglichen, der gegen Verschmutzung und Feuchte bereits vor der Montage in das Ventilgehäuse geschützt ist, bei dem eine einfache Zentrierung des Aktors im Ventilgehäuse und gleichzeitig eine elektrische Isolation des Aktors gegenüber dem Ventilgehäuse und eine gute Wärmeübertragung vom Aktor zum Ventilgehäuse erreicht ist.

Diese Aufgabe wird anspruchsgemäß gelöst.

Gemäß einem wesentlichen Aspekt der Erfindung ist der Aktor wenigstens einschließlich der Kopfplatte von einer elektrisch isolierenden Elastomerhülle umhüllt, so daß der Aktor mit der Elastomerhülle eng an der Innenwand der Axialbohrung des Ventilgehäuses im Bereich des Aktors anliegt. Bevorzugt hat diese Elastomerhülle vor dem Einsatz des Aktors in die Axialbohrung eine konvexe Auswölbung, deren Durchmesser den Innendurchmesser der Axialbohrung des Gehäuses übersteigt und zwar über die gesamte axiale Länge des Aktorkörpers. Dadurch ist der Aktor erfindungsgemäß nach der Montage in das Ventilgehäuse über die gesamte Länge des Aktorkörpers zentriert, in dem Ventilgehäuse elektrisch isoliert und vor der Montage gegen Verschmutzung und Beschädigung geschützt. Gleichzeitig ist ein guter Wärmeübergang vom Aktorkörper zum Ventilgehäuse gesichert. Bei dem erfindungsgemäßen piezoelektrischen Aktor sind wenigstens die Fußplatte durch die Elastomerhülle zusammen mit dem Aktorkörper integriert, und somit führt die den Aktorkörper und wenigstens die an der Fußplatte haftende Elastomerhülle zu einer besseren Zentrierung bei der Montage. Die Integration der Kopf- und Fußplatte sichert auch eine Verdrehung des Aktors, sofern mindestens die Fußplatte im Ventilgehäuse gesichert ist.

Werden die Kopf- und die Fußplatte ganz oder teilweise aus elektrisch isolierendem Werkstoff gefertigt, läßt sich die Kurzschlußgefahr an Kopf und Fuß des Aktors deutlich verbessern. Auch bei metallischer Kopf- und Fußplatte verbessert der Verguß mit der Elastomerhülle bereits die Kurzschlußsicherheit sehr stark.

Durch gezielte Lufteinschlüsse im Elastomer lassen sich bei Bedarf durch die Wärmedehnung entstehende Druckspannungen abbauen.

Bei Bedarf kann die Zentrierung des Aktorkörpers durch eingelegte Zentrierringe aus festerem Polymer verbessert werden.

Da die Elastomerhülle auch die bewegliche Kopfplatte mit umhüllt, dient sie dort dem Aktor als Zentrierung und Führung, ohne daß Verschleiß zwischen der Kopfplatte und dem Ventilgehäuse entsteht.

Der bereits vor der Montage mit der Elastomerhülle vergossene Aktor kann besser und sicherer transportiert und montiert werden.

Optionell ist die Elastomerhülle mit wärmeleitfähigen Zusatzteilchen gefüllt, die die Wärmeleitfähigkeit der Elastomerhülle und damit die Abfuhr der während des Betriebs im Aktorkörper entstehenden Wärme verbessert.

Statt der Elastomerhülle kann auch ein anderes, dehnfähiges Polymer verwendet werden.

Die obigen Vorteile und weitere vorteilhafte Merkmale werden in der nachstehenden mehrere Ausführungsbeispiele eines erfindungsgemäßen piezoelektrischen Aktors beschreibenden Beschreibung noch deutlicher, wenn diese bezugnehmend auf die Zeichnung gelesen wird.

### Zeichnung

- Figur 1: zeigt schematisch einen Längsschnitt durch ein erstes Ausführungsbeispiel eines erfindungsgemäßen, in ein Ventilgehäuse eingebauten piezoelektrischen Aktors;
- Figur 2: zeigt in Form eines schematischen Längsschnitts eine zweites Ausführungsbeispiel eines erfindungsgemäßen piezoelektrischen Aktors vor dessen Einbau in ein Ventilgehäuse;
- Figur 3A: zeigt in Form eines schematischen Längsschnitts ein drittes Ausführungsbeispiel eines erfindungsgemäßen in ein Ventilgehäuse eingebauten piezoelektrischen Aktors;
- Figur 3B: zeigt als Schnittansicht eine alternative Ausführungsform einer mit einer Plasmaspritzschicht versehenen metallischen Fußplatte;
- Figur 4: zeigt in Form eines schematischen Längsschnitts ein viertes erfindungsgemäßes Ausführungsbeispiel eines piezoelektrischen Aktors mit axial verlängerter Kopfplatte; und
- Figur 5: zeigt in Form eines schematischen Längsschnitts ein fünftes Ausführungsbeispiel eines mit Zentrierringen versehenen erfindungsgemäßen piezoelektrischen Aktors vor dessen Einbau in ein Ventilgehäuse.

### Ausführungsbeispiele

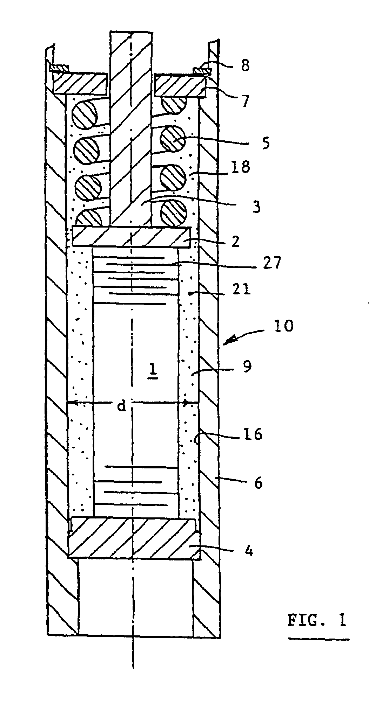

Der in Figur 1 in Form eines schematischen Längsschnitts dargestellte, allgemein mit der Bezugszahl 10 bezeichnete piezoelektrische Aktor hat einen mehrlagigen piezoelektrischen Aktorkörper 1 in Form eines (nicht gezeigten) vielschichtigen Laminats aus aufeinandergeschichteten Lagen piezoelektrischen Materials mit dazwischenliegenden metallischen bzw. elektrisch leitenden, als Elektroden 27 dienenden Schichten. An den Endflächen des Aktorkörpers 1 liegt jeweils eine ventilseitige Kopfplatte 2 mit einem axial ragenden Ventilstößel 3 und gegenüberliegend eine an einem Ventilgehäuse 6 fixierte Fußplatte 4, und der Aktor 10 ist in eine Axialbohrung 16 des aus Stahl bestehenden Ventilgehäuses 6 eingebaut. Stirnseitig ist der Aktor 10 beispielsweise durch eine Schraubenfeder 5 vorgespannt, da der Aktor 10 nur Druckkräfte übertragen kann und bei dynamischem Betrieb keine Zugspannung erleiden darf. Der Kraftschluß der Vorspannung erfolgt über das metallische Ventilgehäuse 6 und die Schulter einer Druckscheibe 7, die mittels eines Sicherungsrings 8 oder eine (in Figur 1 nicht dargestellte) Verschraubung am Ventilgehäuse 6 festgelegt ist.

Der aus dem Aktorkörper 1, der Fußplatte 4 und der Kopfplatte 2 mit dem axial ragenden Ventilstößel 3 bestehende piezoelektrische Aktor 10 wird erfindungsgemäß durch eine elektrisch isolierende Elastomerhülle 9, 18 vervollständigt, die bereits vor dem Einbau des Aktors 10 angebracht werden kann, so daß der so vergossene Aktor 10 besser und sicherer transportiert und montiert werden kann, da die Fußplatte 4 und die Kopfplatte 2 zusammen mit dem Aktorkörper 1 durch die Elastomerhülle 9, 18 integriert sind.

Figur 1 zeigt, daß es möglich ist, auch die Druckfeder 5 durch eine oberhalb der Kopfplatte 2 vorgesehene Elastomerhülle 18 ebenfalls in die Aktoreinheit 10 zu integrieren.

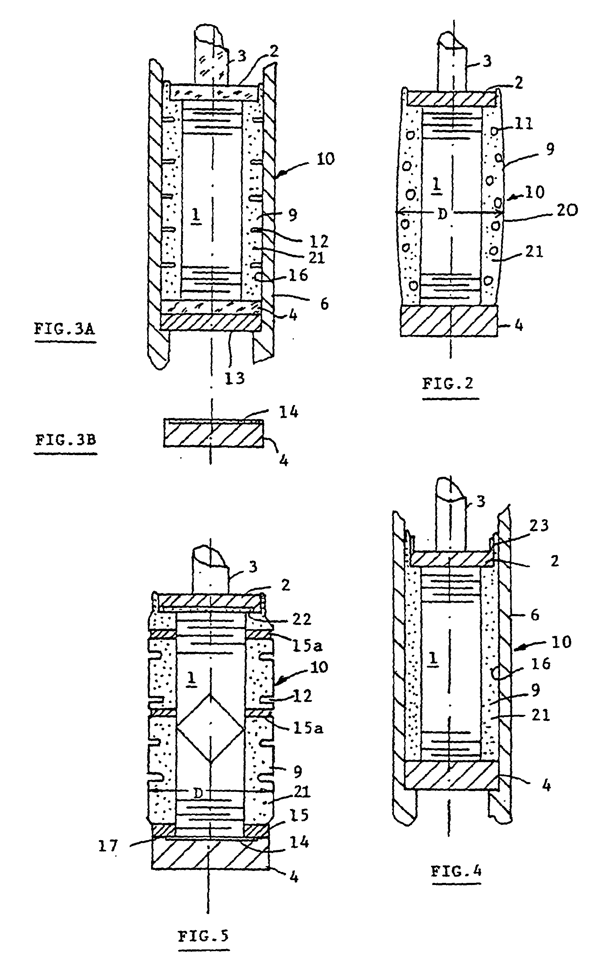

Wie nachstehend anhand der Beschreibung der Figur 2 noch deutlicher wird, kann der Außendurchmesser D der den Aktorkörper 1 mit Kopf- und Fußplatte 2 und 4 und gegebenenfalls auch die Druckfeder 5 umhüllenden Elastomerhülle 9, 18 wenigstens entlang des Aktorkörpers 1 vor dem Einsatz des piezoelektrischen Aktors 10 in die Axialbohrung 16 etwas größer sein, als der Durchmesser d der Axialbohrung 16 des Ventilgehäuses 6, so daß in dem in Figur 1 gezeigten eingebauten Zustand des Aktors 10 die Elastomerhülle 9, 18 eng an die Innenwand des Ventilgehäuses 6 angepreßt ist. Durch diese Maßnahme ist der so gebildete piezoelektrische Aktor 10 ohne weitere Zentrierungsmaßnahmen im Ventilgehäuse 6 zentriert, elektrisch gegenüber dem Ventilgehäuse 6 isoliert und steht außerdem gut wärmeleitend mit dem Ventilgehäuse 6 in Kontakt. Im die Wärmeableitung der Elastomerhülle 9, 18 zum Ventilgehäuse 6 noch zu verbessern, ist die Elastomerhülle 9 mit wärmeleitfähigen Zusatzteilchen 21 gefüllt.

Die Fußplatte 4 ist im Ventilgehäuse 6 gesichert. Durch die Integration der Fußplatte 4 und auch der Kopfplatte 2 mit der Elastomerhülle 9, 18 ist somit, da die Fußplatte 4 im Ventilgehäuse 6 festgelegt ist, der ganze Aktor 10 gegen Verdrehung gesichert. Die zwischen der Kopfplatte 2 und dem Ventilgehäuse 6 liegende Elastomerhülle 9 dient zur Zentrierung und Führung der im Betrieb bewegten Kopfplatte 2 innerhalb des Ventilgehäuses 6, ohne daß Verschleiß an der Kopfplatte 2 zum Gehäuse 6 hin entsteht.

Figur 2 stellt ein zweites Ausführungsbeispiel eines erfindungsgemäßen piezoelektrischen Aktors 10 vor dessen Einsatz in ein Ventilgehäuse dar. Die den Aktorkörper 1 umgebende Elastomerhülle 9 hat einen den Innendurchmesser d der in Figur 2 nicht gezeigten axialen Bohrung 16 des Ventilgehäuses 6 etwas übersteigenden Außendurchmesser D in Form einer nach außen gewölbten Außenkontur 20. Die Auswölbung 20 in Figur 2 kann in verschiedenen Formen ausgeführt werden, z. B. so wie in Figur 2 angedeutet tonnenförmig, in zylindrischer Form (siehe Figur 5) oder auch in konischer Form. Eine so gewölbte Kontur der Elastomerhülle 9 kann eine für die Herstellung, Montage und Funktion zweckmäßige Form haben, sofern ihr Durchmesser D wenigstens abschnittsweise, d. h. im Bereich des Aktorkörpers 1 den Innendurchmesser d der axialen Bohrung 16 im Ventilgehäuse 6 etwas übersteigt (D>d).

Alternativ kann die Montage auch zusätzlich mit einem Zwischenfilm aus Elastomer auf die Außenkontur einer inneren vorher aufgebrachten Elastomerhülle erfolgen. Der frische Elastomerfilm kann danach, d. h. nach der Montage aushärten und dadurch zu einem noch besseren Kontakt mit der Wandung der axialen Bohrung 16 im Ventilgehäuse 6 führen. Somit kann der Aktor 10, anders als in Figur 2 gezeigt, mit zurückgezogener innerer Elastomerhülle hergestellt werden, deren Außendurchmesser kleiner als der Innendurchmesser d der Bohrung ist und der verbleibende Luftspalt nach Montage mit einer frischen Elastomerschicht gefüllt werden.

Abweichend von dem in Figur 1 gezeigten ersten Ausführungsbeispiel des piezoelektrischen Aktors 10 sind bei dem in Figur 2 gezeigten zweiten Ausführungsbeispiel Luftblasen 11 in dem Elastomer 9 eingeschlossen, die die Kompressibilität des Elastomers 9 verbessern. Wie nachstehend anhand des dritten, in Figur 3A gezeigten Ausführungsbeispiels erläutert wird, können statt der Luftblasen 11 gezielt Nuten 12 in der Elastomerhülle 9 angebracht werden. Hierdurch verbessert sich die Montage des Aktors 10 und die Drücke bei Wärmedehnung werden reduziert.

Bei dem in Figur 3A gezeigten dritten Ausführungsbeispiel eines piezoelektrischen Aktors 10 bestehen die Kopfplatte 2 und der daran einstückig anschließende Ventilstößel 3 sowie die Fußplatte 4 aus elektrisch isolierendem Keramikmaterial. Die Fußplatte 4 wird durch eine Metallscheibe 13 aus Festigkeitsgründen unterstützt, kann aber auch vollständig aus Keramik sein. Der Aktorkörper 1 ist durch die Keramikplatten 2, 4, den Stößel 3 und die Elastomerhülle 9 völlig elektrisch isoliert, was die Ausfallsicherheit deutlich erhöht. Statt der aus Keramikmaterial bestehenden Fußplatte 4 kann gemäß Figur 3β auch eine Plasmaspritzschicht 14 auf einer metallischen Fußplatte 4 verwendet werden, die ebenfalls in Verbindung mit der Elastomerhülle 9 für eine elektrische Isolation des Aktors 10 sorgt. Eine solche Plasmaspritzschicht kann auch (obwohl in der Figur 3A und 3β nicht dargestellt) an der zum Aktorkörper 1 weisenden Stirnseite einer (metallischen) Kopfplatte 2 angebracht werden (vergleiche Figur 5).

In dem dritten Ausführungsbeispiel gemäß Figur 3A sind die in dem zweiten Ausführungsbeispiel gemäß Figur 2 in der Elastomerhülle 9 vorgesehenen Lufteinschlüsse 11 durch gezielt angebrachte Nuten 12, z. B. Ringnuten in der Elastomerhülle 9 im Bereich des Aktorkörpers 1 ersetzt.

Bei dem in Figur 4 gezeigten vierten Ausführungsbeispiel eines erfindungsgemäßen piezoelektrischen Aktors 10 ist die seitliche Führung der mit dem Aktorhub bewegten Kopfplatte 2 durch eine axiale Verlängerung 23 der Kopfplatte 2 verbessert, die, wie gezeigt, ebenfalls von der Elastomerhülle 9 umhüllt ist.

Figur 5 zeigt in Form eines schematischen Längsschnitt ein fünftes erfindungsgemäßes Ausführungsbeispiel eines piezoelektrischen Aktors 10, bei dem die metallische Fußplatte 4 und die metallische Kopfplatte 2 durch eine isolierende Plasmaspritzschicht 14 und 22 jeweils gegenüber dem piezoelektrischen Aktorkörper 1 isoliert sind. Zur Zentrierung des Aktorkörpers 1 am Aktor 10 und des Aktors 10 im Gehäuse 6 ist ein zusätzlicher Zentrierring 15 aus Kunststoff auf die Fußplatte 4 aufgeklebt (Klebeschicht 17). Der Zentrierring 15 ist immer so geformt, daß er formschlüssig um den Aktorkörper 1 paßt. Der Vorteil liegt darin, daß die Fußplatte 4 kostengünstig geschliffen und der Ring 15 leicht aufgeklebt werden kann. Der Zentrierring 15 kann aus festerem Polymer bestehen.

Weitere Zentrierringe 15a aus festerem Polymer können mehrfach an beliebiger Stelle des Aktorkörpers 1 angebracht werden, um dessen Zentrierung zu verbessern und die Knickgefahr zu verringern, insbesondere wenn ein gegenüber seinem Querschnitt langer Aktorkörper 1 verwendet wird. Außerdem stabilisieren die Zentrierringe 15a zusammen mit der Elastomerhülle 9 selbst den Aktor gegen Querschwingungen.

Anders als die bei dem in Figur 2 gezeigten Ausführungsbeispiel verwendete rund gewölbte Außenkontur der Elastomerschicht 9 ist bei dem in Figur 5 gezeigten fünften Ausführungsbeispiel die Außenkontur der Elastomerschicht 9 zylindrisch, so daß deren Außendurchmesser D im Bereich des Aktorkörpers 1 den Innendurchmesser d der Bohrung 16 im Ventilgehäuse 6 konstant übersteigt. Der Querschnitt des Aktorkörpers 1 ist in Figur 5 beispielhaft quadratisch. Statt eines quadratischen Querschnitts kann der Aktorkörper 1 bei allen Ausführungsbeispielen auch eine rechteckige, kreisrunde, ovale oder andere Querschnittsform haben. Gleichfalls kann die Bohrung 16 im Ventilgehäuse 6 nicht nur zylindrisch sein, sondern auch eine quadratische oder rechteckige oder auch ovale Kontur haben.

Die Erfindung bietet insbesondere folgende Vorteile:
1. Durch die vor der Montage des Aktors aufgebrachte Elastomerhülle ist der Aktor gegen Verschmutzung und Feuchte geschützt und kann dadurch einfacher gelagert und montiert werden.
2. Die Integration der Kopfplatte und der Fußplatte mit dem Aktorkörper führen bei der Montage zu einer besseren Zentrierung.
3. Eine Verdrehung des Aktorkörpers ist ebenfalls durch die Integration der Kopf- und Fußplatte mit dem Aktorkörper gesichert, sofern mindestens die Fußplatte in dem Ventilgehäuse gesichert ist.
4. Werden die Kopfplatte und die Fußplatte ganz oder teilweise aus elektrisch isolierendem Werkstoff gefertigt, ist die Kurzschlußgefahr an Kopf und Fuß des Aktors deutlich verbessert, wobei der erfindungsgemäß vorgesehene Verguß mit der Elastomerhülle bereits die Kurzschlußsicherheit auch bei metallischer Kopf- und Fußplatte stark erhöht.
5. Durch die Lufteinschlüsse in der Elastomerhülle werden Druckspannungen durch Wärmedehnung abgebaut. Dies wird noch gesteigert, wenn die Lufteinschlüsse durch gezielt eingebrachte Nuten in der Elastomerhülle ersetzt sind.
6. Die Zentrierung des Aktors kann bei Bedarf durch die eingesetzten Zentrierringe aus festerem Polymer verbessert werden.
7. Die Elastomerhülle kann auch an der bewegten Kopfplatte des Aktors diese gegenüber dem ruhenden metallischen Ventilgehäuse zentrieren und führen, ohne daß ein Verschleiß an der Kopfplatte zum Gehäuse hin entsteht.
8. Die vergossene Aktoreinheit kann besser und sicherer transportiert und montiert werden als ein nicht vergossener Aktor.
9. Durch Einbringen wärmeleitfähiger Zusatzteilchen in die Elastomerhülle läßt sich die Wärmeleitfähigkeit der Elastomerhülle und dadurch die Kühlung des Aktors verbessern.

Ein erfindungsgemäß gestalteter piezoelektrischer Mehrlagenaktor läßt sich vorteilhaft für Diesel- oder Benzineinspritzvorrichtungen bzw. -ventile verwenden.

## Patentansprüche

1. Piezoelektrischer Aktor, insbesondere zur Betätigung von Steuerventilen oder Einspritzventilen in Kraftfahrzeugen, mit einem in Form eines vielschichtigen Laminats aus aufeinandergeschichteten Lagen piezoelektrischen Materials und dazwischenliegenden metallischen bzw. elektrisch leitenden, als Elektroden dienenden Schichten (27) gebildeten Aktorkörper (1), an dessen Endflächen je eine ventilseitige Kopfplatte (2) mit einem axial ragenden Ventilstößel (3) und eine gegenüberliegende Fußplatte (4) angebracht sind, wobei der Aktor (10) in einer Axialbohrung (16) eines Ventilgehäuses (6) sitzt und stirnseitig zwischen der Kopfplatte (2) und der Fußplatte (4) durch ein Federelement (5) in axialer Richtung vorgespannt ist, **dadurch gekennzeichnet, daß** der Aktor (10) wenigstens einschließlich der Kopfplatte (2) von einer elektrisch isolierenden Elastomerhülle (9, 19; 18) oder einem anderen dehnfähigen Polymer umhüllt ist, so daß der Aktor (10) mit der Elastomerhülle (9, 19; 18) im eingebauten Zustand eng an der Innenwand der Axialbohrung (16) des Ventilgehäuses (6) im Bereich des Aktors (10) anliegt.

2. Piezoelektrischer Aktor nach Anspruch 1, **dadurch gekennzeichnet, daß** die Elastomerhülle (9, 19) vor dem Einsatz in die Axialbohrung (16) eine konvexe Auswölbung (20) über die gesamte axiale Länge des Aktorkörpers (1) aufweist, deren Durchmesser (D) wenigstens abschnittsweise größer als der Innendurchmesser (d) der Axialbohrung (16) des Ventilgehäuses (6) ist.

3. Piezoelektrischer Aktor nach Anspruch 1 oder 2, **dadurch gekennzeichnet, daß** die Elastomerhülle (9) Luftblasen (11) einschließt.

4. Piezoelektrischer Aktor nach Anspruch 1 oder 2, **dadurch gekennzeichnet, daß** die Außenkontur der Elastomerhülle (9) an definierten Stellen Nuten (12) aufweist.

5. Piezoelektrischer Aktor nach Anspruch 4, **dadurch gekennzeichnet, daß** die Nuten (12) als Ringnuten ausgebildet sind.

6. Piezoelektrischer Aktor nach einem der Ansprüche 1 bis 5, **dadurch gekennzeichnet, daß** die Elastomerhülle (9, 19) mit wärmeleitfähigen Zusatzteilchen (21) gefüllt ist.

7. Piezoeletrischer Aktor nach einem der Ansprüche 1 bis 6, **dadurch gekennzeichnet, daß** wenigstens ein radialer Zentrierring (15, 15a) aus festerem Polymermaterial um den Aktorkörper (1) liegt, wobei die Innenkontur des Zentrierrings (15, 15a) an die Außenkontur des Aktorkörpers (1) und die Außenkontur des Zentrierrings (15, 15a) an die Innenkontur der Axialbohrung (16) des Ventilgehäuses (6) angepaßt ist.

8. Piezoelektrischer Aktor nach einem der Ansprüche 1 bis 7, **dadurch gekennzeichnet, daß** die Elastomerhülle (9, 19) aus einer inneren Hüllschicht (9) um den Aktor (10) und einem bei der Montage des Aktors (10) um die Außenkontur dieser inneren Hüllschicht (9) eingebrachten frischen Elastomer film besteht, der nach der Montage aushärtet.

9. Piezoelektrischer Aktor nach einem der Ansprüche 1 bis 8, **dadurch gekennzeichnet, daß** die Kopfplatte (2) und die Fußplatte (4) des Aktors (10) jeweils aus isolierendem Keramikmaterial bestehen und die Einheit aus dem Aktorkörper (1), der Kopfplatte (2), der Fußplatte (4) sowie der Elastomerhülle (9, 19) gegenüber dem Ventilgehäuse (6) vollständig elektrisch isoliert ist.

10. Piezoelektrischer Aktor nach einem der Ansprüche 1 bis 8, **dadurch gekennzeichnet, daß** die Fußplatte (4) aus Metall besteht und durch eine Plasmaspritzschicht (14) gegenüber dem Aktorkörper (1) isoliert ist.

11. Piezoelektrischer Aktor nach Anspruch 10, **dadurch gekennzeichnet, daß** auch die Kopfplatte (2) aus Metall besteht und durch eine Plasmaspritzschicht (22) gegenüber dem Aktorkörper (1) isoliert ist.

12. Piezoelektrischer Aktor nach einem der Ansprüche 1 bis 11, **dadurch gekennzeichnet, daß** das Federelement (5) eine Schraubenfeder ist, die zwischen die Kopfplatte (2) und eine radiale Innenschulter des Ventilgehäuses (6) gespannt ist.

13. Piezoelektrischer Aktor nach einem der Ansprüche 1 bis 11, **dadurch gekennzeichnet, daß** das Federelement (5) ein Tellerfederpaket ist, das zwischen die Kopfplatte (2) und eine radiale Innenschulter des Ventilgehäuses (6) gespannt ist.

14. Piezoelektrischer Aktor nach Anspruch 12 oder 13, **dadurch gekennzeichnet, daß** die Elastomerhülle (18) auch das Federelement (5) umhüllt.

## Claims

1. Piezoelectric actuator, in particular for the actuation of control valves or injection valves in motor vehicles, with an actuator body (1) which is produced in the form of a multi-layered laminate consisting of plies of piezoelectric material layered one on the other and of metallic or electrically conductive layers (27) lying between them and serving as electrodes and on the end faces of which is mounted in each case a valve-side head plate (2) with an axially projecting valve tappet (3) and an opposite foot plate (4), the actuator (10) being seated in an axial bore (16) of a valve housing (6) and being prestressed in the axial direction on the end face, between the head plate (2) and the foot plate (4), by means of a spring element (5), **characterized in that** the actuator (10), at least including the head plate (2), is encased by an electrically insulating casing (9, 19; 18) consisting of elastomer or of another stretchable polymer, so that, in the installed state, the actuator (10) comes to bear with the elastomeric casing (9, 19; 18) closely against the inner wall of the axial bore (16) of the valve housing (6) in the region of the actuator (10).

2. Piezoelectric actuator according to Claim 1, **characterized in that** the elastomeric casing (9, 19), before insertion into the axial bore (16), has, over the entire axial length of the actuator body (1), a convex bulge (20), the diameter (D) of which is at least partially greater than the inside diameter (d) of the axial bore (16) of the valve housing (6).

3. Piezoelectric actuator according to Claim 1 or 2, **characterized in that** the elastomeric casing (9) includes air bubbles (11).

4. Piezoelectric actuator according to Claim 1 or 2, **characterized in that** the outer contour of the elastomeric casing (9) has grooves (12) at defined points.

5. Piezoelectric actuator according to Claim 4, **characterized in that** the grooves (12) are designed as annular grooves.

6. Piezoelectric actuator according to one of Claims 1 to 5, **characterized in that** the elastomeric casing (9, 19) is filled with thermally conductive accessory particles (21).

7. Piezoelectric actuator according to one of Claims 1 to 6, **characterized in that** at least one radial centring ring (15, 15a) consisting of firmer polymeric material lies around the actuator body (1), the inner contour of the centring ring (15, 15a) being adapted to the outer contour of the actuator body (1), and the outer contour of the centring ring (15, 15a) being adapted to the inner contour of the axial bore (16) of the valve housing (6).

8. Piezoelectric actuator according to one of Claims 1 to 7, **characterized in that** the elastomeric casing (9, 19) consists of an inner encasing layer (9) around the actuator (10) and of a fresh elastomeric film which is introduced around the outer contour of this inner encasing layer (9) during the mounting of the actuator (10) and which cures after mounting.

9. Piezoelectric actuator according to one of Claims 1 to 8, **characterized in that** the head plate (2) and the foot plate (4) of the actuator (10) consist in each case of insulating ceramic material, and the unit composed of the actuator body (1), of the head plate (2), of the foot plate (4) and of the elastomeric casing (9, 19) is completely insulated electrically with respect to the valve housing (6).

10. Piezoelectric actuator according to one of Claims 1 to 8, **characterized in that** the foot plate (4) consists of metal and is insulated with respect to the actuator body (1) by means of a plasma-spray layer (14).

11. Piezeoelectric actuator according to Claim 10, **characterized in that** the head plate (2) also consists of metal and is insulated with respect to the actuator body (1) by means of plasma-spray layer (22).

12. Piezeoelectric actuator according to one of Claims 1 to 11, **characterized in that** the spring element (5) is a helical spring which is tensioned between the head plate (2) and a radial inner shoulder of the valve housing (6).

13. Piezeoelectric actuator according to one of Claims 1 to 11, **characterized in that** the spring element (5) is a cup-spring assembly which is tensioned between the head plate (2) and a radial inner shoulder of the valve housing (6).

14. Piezeoelectric actuator according to Claim 12 or 13, **characterized in that** the elastomeric casing (18) also encases the spring element (5).

## Revendications

1. Actionneur piézo-électrique, notamment pour commander des soupapes de commande ou des injecteurs de véhicules automobiles, comprenant un corps d'actionneur (1) formé d'un produit laminé multicouches composé de nappes superposées de matière piézo-électrique avec interposition de couches (27) métalliques ou conductrices d'électricité servant d'électrodes, et dont les surfaces d'extrémité comportent, l'une, une plaque de tête (2) située du côté de la soupape avec un poussoir de soupape (3) passant axialement, et à l'opposé une plaque de base (4), l'actionneur (10) étant logé dans un perçage axial (16) d'un boîtier de soupape (6) alors que du côté frontal il est précontraint dans la direction axiale par un élément de ressort (5) entre la plaque de tête (2) et la plaque de base (4),
**caractérisé en ce que**
l'actionneur et au moins sa plaque de tête (2) sont entourés par une enveloppe d'élastomère (9, 19 ; 18) isolante électrique ou un autre polymère extensible de façon qu'à l'état monté, l'actionneur (10) avec son enveloppe en élastomère (9, 19 ; 18) est appliqué étroitement contre la paroi intérieure du perçage axial (16) du boîtier de soupape (6) au niveau de l'actionneur (10).

2. Actionneur piézo-électrique selon la revendication 1,
**caractérisé en ce que**
l'enveloppe en élastomère (9, 19) présente une forme bombée convexe (20) avant d'être logée dans le perçage axial (16), cette forme s'étendant sur toute la longueur axiale du corps (1) de l'actionneur et le diamètre (D) est au moins par segments, supérieur au diamètre intérieur (d) du perçage axial (16) du boîtier de soupape (6).

3. Actionneur piézo-électrique selon la revendication 1 ou 2,
**caractérisé en ce que**
l'enveloppe d'élastomère (9) contient des bulles d'air (11).

4. Actionneur piézo-électrique selon la revendication 1 ou 2,
**caractérisé en ce que**
le contour extérieur de l'enveloppe en élastomère (9) présente des rainures (12) à des endroits définis.

5. Actionneur piézo-électrique selon la revendication 4,
**caractérisé en ce que**
les rainures (12) sont des rainures annulaires.

6. Actionneur piézo-électrique selon l'une des revendications 1 à 5,
**caractérisé en ce que**
l'enveloppe d'élastomère (9, 19) est remplie de particules additives (21) thermoconductrices.

7. Actionneur piézo-électrique selon l'une des revendications 1 à 6,
**caractérisé par**
au moins une bague de centrage (15, 15a) radiale en une matière polymère plus dure entourant le corps (1) de l'actionneur, le contour intérieur de la bague de centrage (15, 15a) étant adapté au contour extérieur du corps (1) de l'actionneur, alors que le contour extérieur de la bague de centrage (15, 15a) est adapté au contour intérieur du perçage axial (16) du boîtier de soupape (6).

8. Actionneur piézo-électrique selon l'une des revendications 1 à 7,
**caractérisé en ce que**
l'enveloppe d'élastomère (9, 19) est formée d'une couche-enveloppe (9), intérieure, entourant l'actionneur (10) et d'un film d'élastomère, frais, appliqué contre le contour extérieur de cette couche-enveloppe intérieure (9) lors du montage de l'actionneur (10), ce film durcissant après le montage.

9. Actionneur piézo-électrique selon l'une des revendications 1 à 8,
**caractérisé en ce que**
la plaque de tête (2) et la plaque de base (4) de l'actionneur (10) sont chacune en une matière céramique isolante, et l'ensemble formé par le corps (1) de l'actionneur, la plaque de tête (2) et la plaque de base (4) ainsi que les enveloppes en élastomère (9, 19) est totalement isolé électriquement par rapport au boîtier de soupape (10).

10. Actionneur piézo-électrique selon l'une des revendications 1 à 8,
**caractérisé en ce que**
la plaque de base (4) est en métal et elle est isolée par rapport au corps (1) de l'actionneur par une couche projetée par plasma (14).

11. Actionneur piézo-électrique selon l'une des revendications 10,
**caractérisé en ce que**
la plaque de tête (2) est en métal et elle est isolée par rapport au corps (1) de l'actionneur par une couche (22) projetée par plasma.

12. Actionneur piézo-électrique selon l'une des revendications 1 à 11,
**caractérisé en ce que**
l'élément de ressort (5) est un ressort hélicoïdal serré entre la plaque de tête (2) et un épaulement radial intérieur du boîtier de soupape (6).

13. Actionneur piézo-électrique selon l'une des revendications 1 à 11,
**caractérisé en ce que**
l'élément de ressort (5) est un paquet de ressort Belleville serré entre la plaque de tête (2) et un épaulement radial intérieur du boîtier de soupape (6).

14. Actionneur piézo-électrique selon les revendications 12 ou 13,
**caractérisé en ce que**
l'enveloppe d'élastomère (18) enveloppe également l'élément de ressort (5).
